# FASCICULE DE BREVET EUROPEEN

(11) **EP 2 715 380 B1**
(45) Date de publication et mention de la délivrance du brevet: **06.03.2019**
(21) Numéro de dépôt: 12725730.1
(22) Date de dépôt: 01.06.2012
(51) Int. Cl.: G01R 31/02, B60L 3/00, G01R 27/18, B60L 3/04

(54) **DISPOSITIF DE DETECTION D'UN DEFAUT D'ISOLEMENT**
VORRICHTUNG ZUM NACHWEIS EINES DEFEKTS BEI EINER ISOLIERUNG
DEVICE FOR DETECTING A DEFECT IN INSULATION

(30) Priorité: 01.06.2011 FR 1154851
(43) Date de publication de la demande: 09.04.2014
(73) Titulaire: Commissariat à l'Énergie Atomique et aux Énergies Alternatives, 75015 Paris (FR)
(72) Inventeur: CHATROUX, Daniel, F-38470 Teche (FR); CARCOUET, Sébastien, F-38450 Vif (FR); DAUCHY, Julien, F-38160 Chatte (FR)
(74) Mandataire: Colombo, Michel
(86) Numéro de dépôt international: PCT/EP2012/060396
(87) Numéro de publication internationale: WO 2012/171818

(56) Documents cités:
- EP-A1- 1 857 825
- EP-A1- 2 105 753
- EP-A1- 2 333 568
- WO-A1-2008/088448
- WO-A1-2009/043772
- FR-A1- 2 721 407
- GB-A- 2 317 278
- JP-A- 8 163 704
- US-A1- 2003 234 653
- US-A1- 2004 212 371
- US-A1- 2007 285 057

## Description

L'invention concerne l'isolement d'un réseau ou d'une alimentation électrique à tension continue par rapport à la terre.

Les systèmes électriques de forte puissance à tension continue connaissent un développement important. En effet, de nombreux systèmes de transport incluent une alimentation de tension continue.

Les véhicules hybrides combustion/électrique ou électriques incluent notamment des batteries de forte puissance. Pour obtenir le niveau de tension adéquat, on place en série plusieurs accumulateurs électrochimiques. Pour obtenir de fortes puissances et capacités, on place plusieurs groupes d'accumulateurs en série. Le nombre d'étages (nombre de groupes d'accumulateurs) et le nombre d'accumulateurs en parallèle dans chaque étage varient en fonction de la tension, du courant et de la capacité souhaités pour la batterie. L'association de plusieurs accumulateurs est appelée une batterie d'accumulateurs. Les accumulateurs électrochimiques utilisés pour de tels véhicules sont généralement du type lithium ion pour leur capacité à stocker une énergie importante avec un poids et un volume contenus. Les technologies de batterie de type Lithium ion phosphate de fer LiFePO4 font l'objet d'importants développements du fait d'un niveau de sécurité intrinsèque élevé, au détriment d'une densité de stockage d'énergie un peu en retrait.

De telles batteries sont utilisées pour entraîner un moteur électrique à courant alternatif par l'intermédiaire d'un onduleur. Les niveaux de tension nécessaires pour de tels moteurs atteignent plusieurs centaines de Volts, typiquement de l'ordre de 400 Volts. De telles batteries comportent également une forte capacité afin de favoriser l'autonomie du véhicule en mode électrique. Plusieurs raisons techniques spécifiques à l'application automobile amènent à l'utilisation d'un isolement entre la masse mécanique du véhicule (formée par le châssis et la carrosserie métalliques du véhicule, et donc accessibles à l'utilisateur) et les potentiels de la batterie. La raison principale est qu'il n'est pas envisageable lors d'un premier défaut d'isolement en roulage de déconnecter instantanément la batterie de traction. Par exemple, dans le cas où l'un des pôles de la batterie est relié à la mécanique et que le défaut d'isolement apparait sur l'autre pôle. Ceci se traduit par un court-circuit et la fusion immédiate du fusible de protection. Cela aurait pour effet de rendre le véhicule dangereux. Du fait de la disparition de la puissance de traction ou du freinage récupératif, ceci oblige donc à devoir isoler la batterie et surveiller cet isolement pour des raisons de sécurité des personnes par un contrôleur d'isolement. En effet, si lors d'un premier défaut il n'y a aucun risque pour l'utilisateur, il convient de l'alerter de ce premier défaut avant l'apparition d'un second défaut ayant pour effet de déconnecter la batterie de traction car provoquant un court-circuit entre les bornes positive et négative de la batterie. De plus, lors de ce second défaut, la tension de la batterie serait directement reliée à la masse mécanique du véhicule et l'utilisateur serait donc potentiellement en contact avec celle-ci. Du fait du risque potentiel d'une telle source d'énergie pour les utilisateurs, l'isolement et le contrôle de l'isolement entre la batterie et la masse mécanique doivent être particulièrement soignés. Toute partie conductrice du véhicule doit être isolée par rapport aux masses. Cet isolement est réalisé par l'utilisation de matériaux isolants. L'isolement peut se détériorer avec le temps (à cause des vibrations, des chocs mécaniques, de la poussière, etc.), et donc mettre la masse mécanique sous un potentiel dangereux.

Par ailleurs, il peut être envisagé d'utiliser un chargeur non isolé galvaniquement du réseau électrique. La masse mécanique du véhicule étant normativement reliée à la terre lors des recharges et le régime de neutre utilisé classiquement (régime TT) en résidentiel connectant le neutre à la terre, cela revient à connecter pendant les recharges la masse mécanique du véhicule à un des potentiels de la batterie. Pendant ces recharges, la tension complète de la batterie est donc appliquée aux bornes de l'isolement contrairement au cas nominal où seulement la moitié de cette tension est appliquée et surtout contrôlée. Cet isolement pourrait ne pas être capable de tenir la tension complète créant un second défaut instantanément ayant pour conséquence un court-circuit.

Un véhicule électrique selon l'état de la technique présente typiquement une batterie destinée à l'alimentation d'un moteur électrique triphasé. La batterie comprend des accumulateurs électrochimiques. Un dispositif de protection muni de fusibles est connecté aux bornes de la batterie. Un dispositif de contrôle d'isolement est également connecté aux bornes de la batterie et raccordé à la masse mécanique du véhicule. Le dispositif de contrôle d'isolement est connecté à un calculateur pour lui signaler les défauts d'isolement détectés. Ce calculateur est alimenté par une batterie de réseau de bord. Les bornes de la batterie appliquent des tensions +Vbat et -Vbat sur les entrées continues d'un onduleur par l'intermédiaire d'un système de coupure. Le système de coupure comprend des contacteurs de puissance commandés par le calculateur. Le moteur électrique est connecté à la sortie alternative de l'onduleur. Différents types de contrôle d'isolement sont connus de l'état de la technique.

Le document FR2671190 décrit notamment un dispositif de contrôle d'isolement d'un réseau électrique à tension continue. Ce document décrit un pont résistif injectant une composante alternative (environ 30 V) à basse fréquence (entre 4 et 10Hz). Un circuit de détection mesure un courant traversant une impédance d'isolement et une résistance de mesure jusqu'à la masse. La conception d'un tel circuit implique un compromis dans le dimensionnement des résistances du pont résistif.

Le pont résistif induit une consommation électrique restant relativement importante afin de garder une précision de mesure convenable. Une telle consommation de courant peut s'avérer incompatible avec une application dans les systèmes embarqués, par exemple du fait de la baisse d'autonomie d'un véhicule électrique. De plus, un tel dispositif est relativement coûteux notamment du fait de l'utilisation d'un générateur basse fréquence dimensionné pour une tension continue élevée. En outre, le circuit de détection ne permet que la détection d'un défaut d'isolement entre une des bornes et la masse, mais pas la détection d'un défaut d'isolement entre l'autre borne et la masse. Par ailleurs, un tel dispositif de contrôle est sensible à des faux positifs puisqu'il détecte un défaut d'isolement lorsque des condensateurs de mode commun présents dans l'onduleur sont parcourus par des courants alternatifs.

Dans une autre solution usuellement mise en oeuvre dans un véhicule électrique 1, le dispositif de contrôle d'isolement comprend un diviseur de tension résistif. Un microcontrôleur est connecté entre le point milieu du diviseur de tension et la masse mécanique. Les résistances du diviseur de tension de part et d'autre du point milieu sont identiques. Ainsi, en l'absence de défaut d'isolement, la tension sur l'entrée du microcontrôleur est nulle et aucun défaut d'isolement n'est signalé. Lors de l'apparition d'un défaut d'isolement entre une des bornes de la batterie et la masse mécanique, le potentiel du point milieu du diviseur de tension est décalé. Une tension apparaît alors sur l'entrée du microcontrôleur, ce qui génère un signal de défaut d'isolement.

Un circuit de traitement est connecté entre le point milieu et l'entrée du microcontrôleur. Ce circuit de traitement comprend notamment une résistance de mesure connectée entre un potentiel -Vcc généré à partir de la batterie de réseau de bord du véhicule. Un premier amplificateur opérationnel en inverseur présente une alimentation double avec un potentiel à -Vcc et un potentiel à +Vcc. L'entrée non inverseuse de ce premier amplificateur est connectée à - Vcc. L'entrée inverseuse de ce premier amplificateur est connectée au point milieu par l'intermédiaire d'une deuxième résistance et d'un circuit additionneur qui relève le potentiel sur l'entrée inverseuse de Vcc/2. Un deuxième amplificateur opérationnel en inverseur présente une alimentation double avec un potentiel à -Vcc et un potentiel à +Vcc. L'entrée non inverseuse de ce deuxième amplificateur est connectée à -Vcc. L'entrée inverseuse de ce deuxième amplificateur est connectée à la sortie du premier amplificateur opérationnel par l'intermédiaire d'une troisième résistance. La sortie du deuxième amplificateur opérationnel est connectée à l'entrée du microcontrôleur.

Cette solution s'avère relativement coûteuse et nécessite de nombreux composants. De plus, pour assurer une capacité de détection suffisante pour différents niveaux de charge des batteries, les résistances présentes dans le diviseur de tension doivent présenter une valeur relativement réduite, de l'ordre de 50 KΩ. Ces résistances induisent alors une consommation électrique continue relativement importante au détriment de l'autonomie fournie par la batterie. Le circuit de traitement induit également une consommation électrique non négligeable. Elle nécessite également une alimentation à la fois négative et positive ce qui rajoute du coût et de la complexité. Par ailleurs, l'alimentation négative nécessaire n'est utilisée que pour cette fonction. En outre, il est souhaitable de pouvoir assurer à la fois une protection de l'utilisateur contre un courant de toucher et une précision suffisante de la quantification du défaut d'isolement.

Le document WO2008/088448 décrit un dispositif de détection et de compensation d'un courant de défaut d'isolement, dans une application en haute tension d'une machine électrique. Ce document vise aussi à détecter des défauts d'isolement équilibrés entre les deux bornes d'une batterie haute tension. Un circuit détermine un décalage de tension lié à un défaut d'isolement. Le circuit commande alors un interrupteur connecté à un cadre de la machine pour injecter un courant de compensation afin d'équilibrer le défaut d'isolement.

Le document US2004/0212371 décrit un dispositif d'alimentation électrique comportant un dispositif de détection de défaut d'isolation. Ce dispositif comprend notamment une alimentation électrique et un dispositif de détection de défaut d'isolement. Ce dispositif commande des sources de courant pour injecter une partie des courants générés dans des résistances de détection.

Le document EP2333568 décrit un dispositif de détermination d'une résistance de défaut d'isolement. Des cycles de mesure sont mis en oeuvre, pour mesurer une tension entre une première borne haute tension et une tension de référence, mesurer une tension entre les première et deuxième bornes haute tension, mesurer une tension entre la deuxième borne haute tension et la tension de référence et mesurer une tension entre les première et deuxième bornes haute tension. Le courant entre les première et deuxième bornes haute tension est mesurée et on vérifie la variation de ce courant.

L'invention vise à résoudre un ou plusieurs de ces inconvénients. L'invention porte ainsi sur un dispositif d'alimentation électrique selon revendication 1, avec variantes préférées dans les revendications dépendentes.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un exemple de véhicule à moteur électrique alimenté par batterie;
- la figure 2 est une représentation schématique d'un dispositif de détection de défaut d'isolement ;
- les figures 3 et 4 illustrent les configurations du dispositif de détection de défaut d'isolement durant deux phases de contrôle ;
- la figure 5 est une représentation schématique d'un circuit de quantification du courant de fuite d'un premier mode de réalisation ;
- la figure 6 est une représentation schématique d'un circuit de quantification de courant de fuite d'un deuxième mode de réalisation.

L'invention propose un dispositif d'alimentation électrique incluant une source de tension continue susceptible d'induire une électrocution et appliquant une tension nominale Vm entre ses bornes. Un dispositif de détection de défaut d'isolement comprend des première et deuxième bornes d'entrée connectées aux bornes de la source de tension. Des première et deuxième impédances sont connectées en série entre les bornes d'entrée. Un circuit de détection de courant est connecté entre une masse électrique et un point intermédiaire entre les première et deuxième impédances. Ces première et deuxième impédances présentent chacune une valeur d'impédance Z comprise entre Zmin et Zmax, avec Zmin= Vm/Imax et Zmax=1,5*Vm/Imax, Imax étant un courant de défaut d'isolement maximal défini par un seuil de sécurité normé. Le circuit de détection de courant comprend un microcontrôleur dont la borne d'entrée reçoit une tension Vcc proportionnelle au courant de défaut d'isolement provenant du point intermédiaire. La borne d'entrée est connectée au point intermédiaire de deux impédances, qui la raccordent respectivement à la masse et à une alimentation. Ces deux impédances présentent chacune une valeur d'impédance Zt comprise entre Ztmin et Ztmax, avec Ztmin = Z*Vcc/(4*Vm) et Ztmax = Z * Vcc/2Vm. L'alimentation est à un niveau au moins dix fois inférieur au niveau de tension de la source de tension continue.

L'invention permet de réaliser la mesure de courant de fuite avec un minimum de composants, avec des composants de coût réduit et avec une alimentation unique du circuit de mesure. L'invention permet en outre d'assurer la protection des personnes contre un courant de toucher, tout en bénéficiant d'une quantification précise du courant de défaut d'isolement.

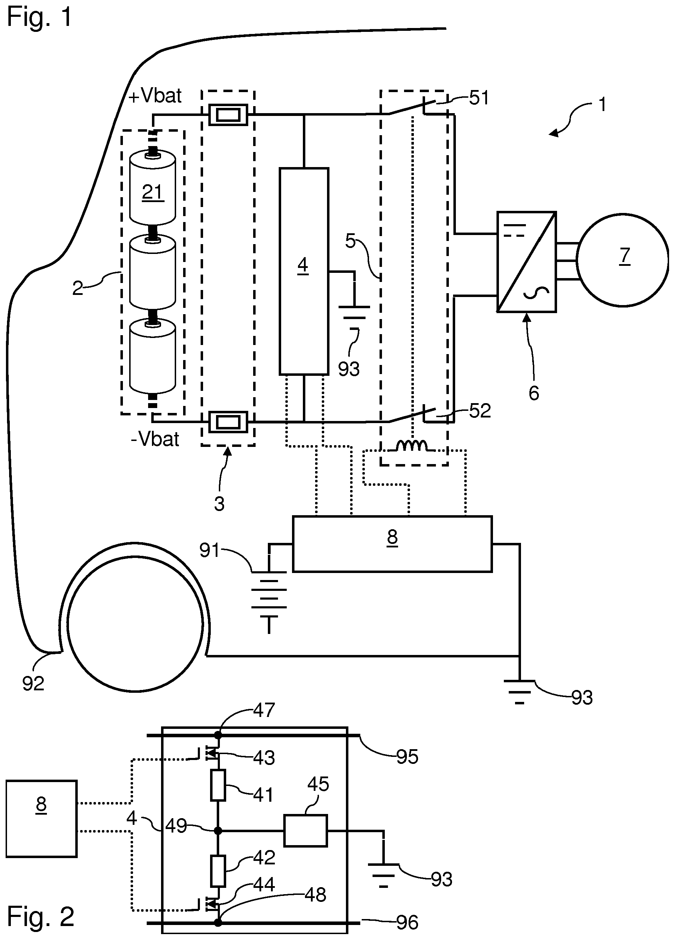

La figure 1 illustre un exemple de véhicule 1 mettant en oeuvre un mode de réalisation de l'invention. Le véhicule 1 est un véhicule électrique comprenant de façon connue en soi une batterie 2 incluant des accumulateurs électrochimiques 21 connectés en série. La batterie 2 comprend un grand nombre d'accumulateurs 21 connectés en série, typiquement entre 40 et 150 accumulateurs en fonction de la tension nécessaire et du type d'accumulateurs utilisé. La tension aux bornes de la batterie 2 chargée est typiquement de l'ordre de 400 V. La batterie 2 applique une tension +Vbat sur une première borne, et une tension -Vbat sur une deuxième borne. Les accumulateurs 21 sont connectés en série par l'intermédiaire de connexions électriques de puissance. Les bornes de la batterie 2 sont connectées à une interface continu d'un onduleur 6. Un moteur électrique 7 est connecté sur une interface alternatif de l'onduleur 6.

La connexion entre les bornes de la batterie 2 et l'interface continu de l'onduleur 6 est réalisée par l'intermédiaire d'un circuit de protection 3 et par l'intermédiaire d'un circuit d'accouplement de puissance 5. Le circuit de protection 3 peut comprendre de façon connue en soi des fusibles configurés pour ouvrir la connexion lors d'un court-circuit. Le circuit d'accouplement de puissance 5 comprend des interrupteurs 51 et 52 permettant de connecter/déconnecter sélectivement les bornes de la batterie 2 à l'interface continu de l'onduleur 6. L'ouverture/fermeture des interrupteurs 51 et 52 est commandée par un circuit de commande 8, typiquement un calculateur de supervision du fonctionnement de la batterie 2. Le circuit de commande 8 est typiquement alimenté par l'intermédiaire d'une batterie 91 d'alimentation du réseau de bord du véhicule 1, présentant un niveau de tension très inférieur à celui de la batterie 2. Le circuit de commande 8 est typiquement connecté à la masse mécanique 93, incluant le châssis et la carrosserie 92 métalliques du véhicule 1.

Un dispositif de détection d'un défaut d'isolement 4 est connecté aux bornes de la batterie 2 et à la masse mécanique 93. Un mode de réalisation d'un tel dispositif de détection 4 est détaillé schématiquement à la figure 2. Le dispositif de détection 4 comporte des bornes d'entrée 47 et 48 sur lesquelles sont appliquées respectivement les tensions +Vbat et -Vbat par l'intermédiaire des connexions de puissance 95 et 96. Le dispositif de détection 4 comporte une première impédance 41 et une deuxième impédance 42 (en l'occurrence des résistances) connectées en série entre la première borne 47 et la deuxième borne 48. Les impédances 41 et 42 sont connectées par l'intermédiaire d'un point intermédiaire 49 et sont de préférence de valeurs sensiblement identiques. Un premier interrupteur 43 est connecté en série avec la première impédance 41 entre la borne 47 et le point intermédiaire 49. Un deuxième interrupteur 44 est connecté en série avec la deuxième impédance 42 entre la deuxième borne 48 et le point intermédiaire 49. Les interrupteurs 43 et 44 sont en l'occurrence des transistors MOSFET. D'autres types d'interrupteurs commandés peuvent bien entendu être utilisés. Le circuit de commande 8 commande l'ouverture/fermeture respective des interrupteurs 43 et 44. Le dispositif de détection 4 comporte en outre une connexion avec la masse mécanique 93. Le dispositif de détection 4 comprend un circuit de détection 45 d'un courant de défaut d'isolement, connecté entre un point intermédiaire 49 et la masse mécanique 93. Le circuit de détection 45 est configuré pour recevoir le courant de défaut d'isolement éventuel traversant la première ou la deuxième impédance, lorsque l'interrupteur en série avec l'une de celle-ci est fermé.

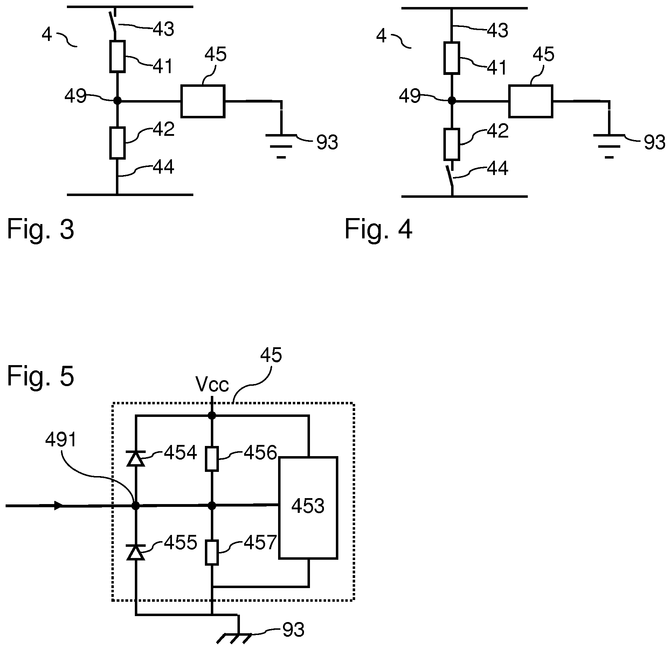

Comme illustré à la figure 3, pour tester l'isolement entre la borne +Vbat de la batterie 2 et la masse mécanique 93, le circuit de commande 8 ouvre l'interrupteur 43 et ferme l'interrupteur 44. On pourrait cependant également envisager de tester l'isolement entre les bornes de la batterie 2 et la masse mécanique 93 en réalisant la fermeture simultanée des interrupteurs 43 et 44. Le circuit de détection de courant 45 est alors connecté en série avec l'impédance 42 entre la borne -Vbat et la masse mécanique 93. En cas de défaut d'isolement côté +Vbat, un circuit se forme par l'intermédiaire du défaut d'isolement entre la borne +Vbat et la masse 93 et un courant traverse alors le circuit de détection 45.

Comme illustré à la figure 4, pour tester l'isolement entre la borne -Vbat de la batterie 2 et la masse mécanique 93, le circuit de commande 8 ouvre l'interrupteur 44 et ferme l'interrupteur 43. Le circuit de détection de courant 45 est alors connecté en série avec l'impédance 41 entre la borne +Vbat et la masse mécanique 93. En cas de défaut d'isolement côté -Vbat, un circuit se forme par l'intermédiaire du défaut d'isolement entre la borne -Vbat et la masse 93 et un courant traverse alors le circuit de détection 45.

Par l'utilisation des interrupteurs 43 et 44, la consommation électrique du dispositif de détection 4 peut être particulièrement réduite, le rapport cyclique de fermeture des interrupteurs 43 et 44 pouvant être particulièrement réduit. Le dispositif de détection 4 n'affecte donc que marginalement l'autonomie de la batterie 2. On peut par exemple envisager de fermer chaque interrupteur 43 et 44 à un intervalle temporel compris entre 2 et 30 secondes (par exemple toutes les 10 secondes) durant le fonctionnement du véhicule 1. La vitesse de commutation des transistors 43 et 44 sera suffisamment réduite pour limiter la génération de perturbations électromagnétiques dans le circuit électrique du véhicule 1. Avec un rapport cyclique de fermeture très réduit des interrupteurs 43 et 44, on peut utiliser des valeurs pour les impédances 41 et 42 relativement réduites, ce qui permet d'accroître la sensibilité du dispositif de détection 4, sans altérer significativement l'autonomie de la batterie 2. Lorsque la masse mécanique 93 est accessible aux utilisateurs, (par exemple la carrosserie du véhicule 1), le courant maximum traversant cette masse mécanique lors de l'apparition d'un premier défaut d'isolement doit être inférieur à un courant de défaut d'isolement maximal Imax défini par un seuil de sécurité normé. Le courant de défaut d'isolement sera par exemple défini inférieur à 3,5mA (valeur de Imax détaillée notamment dans le document NF EN61851-21 (page 8 - chapitre 8.2). Les impédances 41 et 42 présenteront à cet effet chacune une valeur d'impédance au moins égale à Zmin, avec Zmin=Vm/Imax, et Vm la tension nominale appliquée par la batterie 2 entre les bornes 47 et 48. De façon générale, on utilisera des résistances 41 et 42 présentant une valeur de résistance supérieure à 100KΩ. Les résistances 41 et 42 peuvent également être utilisées comme protection contre les surtensions provenant du réseau permettant la protection des transistors 43 et 44 pour l'utilisation d'un chargeur extérieur non isolé assurant la recharge de la batterie 2. Les résistances 41 et 42 assurent également une atténuation de l'amplitude du courant à travers le circuit de détection 45.

Afin de conserver un seuil de détection d'un défaut d'isolement suffisamment bas, les impédances 41 et 42 présentent chacune une valeur d'impédance Z au plus égale à Zmax, avec Zmax=1,5*Vm/Imax.

Avantageusement, les résistances 41 et 42 sont formées de plusieurs résistances en série, de sorte que si l'une des résistances en série se met en court-circuit, les résistances en série restantes protègent le dispositif de détection 4 contre un court-circuit.

Avantageusement, les résistances 41 et 42 ont un mode de défaillance en circuit ouvert, et sont par exemple réalisées sous forme de résistances bobinées. Lors de la défaillance d'une des résistances 41 ou 42, le dispositif de détection 4 est malgré tout protégé contre un court-circuit.

La figure 5 illustre un premier mode de réalisation du circuit de détection 45, permettant de déterminer l'amplitude du courant de défaut d'isolement, et ainsi d'analyser son évolution dans le temps. Le circuit de détection 45 inclut un microcontrôleur 453. Le microcontrôleur 453 est connecté à l'entrée 491 et à la masse mécanique 93, et est alimenté par le potentiel Vcc. La tension Vcc peut être dérivée de la batterie 91. Cette tension pourra par exemple être de 3,3V, ce qui correspond à un niveau d'alimentation très courant pour des circuits électroniques. Une résistance 456 est connectée entre Vcc et l'entrée 491. Une diode 454 est avantageusement connectée en parallèle de la résistance 456.

Une résistance 457 est connectée entre Vcc et l'entrée 491. Une diode 455 est avantageusement connectée en parallèle de la résistance 457. La différence de potentiel Vcc appliqué aux bornes des résistances 456 et 457 en série est au moins dix fois inférieur au niveau de tension de la source continue (le niveau de tension nominal pour la batterie 2), afin de garantir à la fois la sécurité des utilisateurs en contact avec la masse 93, et afin de pouvoir réaliser le circuit 45 avec des composants basse tension.

Les résistances 456 et 457 sont de mêmes valeurs. Sans courant de défaut d'isolement, la tension sur l'entrée 491 est à la valeur Vcc/2.

Tout courant de défaut d'isolement, quel que soit son sens, modifie la tension sur l'entrée 491. En cas de défaut d'isolement avec la borne 47, la tension lue sur l'entrée 491 du microcontrôleur 453 est accrue par rapport à Vcc/2, avec une amplitude pouvant atteindre une valeur de R/2*Idef (avec R la valeur de la résistance 456 ou 457 et Idef le courant de défaut provenant du point intermédiaire 49). En cas de défaut d'isolement avec la borne 48, la tension lue sur l'entrée 491 du microcontrôleur 453 est réduite par rapport à Vcc/2, avec une amplitude pouvant atteindre une valeur de R/2*Idef.

En fonction de la valeur de tension lue sur l'entrée 491, le microcontrôleur 453 peut déterminer précisément l'amplitude du défaut d'isolement. Ce résultat est obtenu au moyen d'un circuit particulièrement simple, en ne nécessitant pas l'utilisation d'alimentations ayant des potentiels opposés. La valeur de tension lue sur l'entrée 491 peut être fournie au circuit de contrôle 8. Le microcontrôleur 453 peut par exemple générer un signal d'amplitude proportionnelle à la tension sur l'entrée 491 et fournir ce signal au circuit de contrôle 8.

Avantageusement, la tension Vcc est connectée à l'entrée 491 par l'intermédiaire de la résistance 456 et appliquée comme tension d'alimentation du microcontrôleur 453. Une seule alimentation est ainsi nécessaire et peut aisément être dérivée de la tension de la batterie 91. Une batterie de réseau de bord présente typiquement une tension nominale inférieure à 14 V pour un véhicule particulier et une tension nominale inférieure à 25 V pour un bus ou un camion.

Les diodes 454 et 455 permettent avantageusement de protéger le microcontrôleur 453 contre des surtensions provenant du réseau électrique, en particulier lors de l'utilisation d'un chargeur non isolé. En effet, si une tension importante apparaît en mode commun ou en mode différentiel aux bornes de la batterie 2, cette tension contribue à faire circuler un courant important dans les résistances 456 ou 457, au risque d'une surtension sur l'entrée 491. Les diodes 454 et 455 permettent ainsi de limiter la tension sur l'entrée 491 entre des valeurs -Vd et Vcc+Vd (avec Vd la tension de seuil des diodes 456 et 457). Les diodes 454 et 455 permettent également d'obtenir à la fois une bonne sensibilité de mesures et une consommation électrique réduite. Avec des résistances 456 et 457 de faible amplitude, les diodes 454 et 455 permettront d'écrêter les courants de défaut d'isolement importants, ou d'obtenir une bonne sensibilité pour des courant plus faibles.

En pratique, la masse 93 n'est pas placée au potentiel du point intermédiaire 49, mais à un potentiel décalé d'une valeur de Vcc/2. Avec les valeurs de Vcc envisagées (typiquement inférieures à 25 V), ce décalage de potentiel de la masse 93 n'induit ni des problèmes de fonctionnement, ni des problèmes de sécurité.

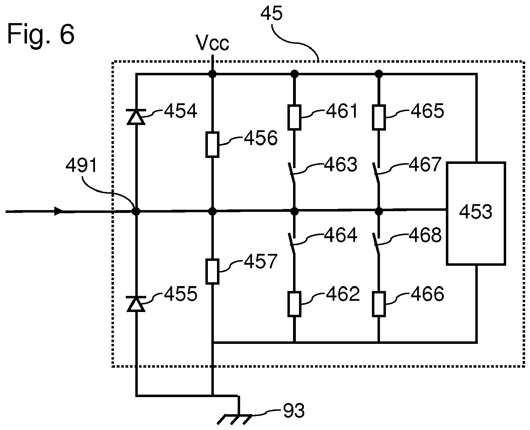

La figure 6 illustre un deuxième mode de réalisation du circuit de détection 45, permettant de modifier la sensibilité en fonction de l'amplitude du courant de fuite. Le circuit de détection de ce mode de réalisation est sensiblement identique à celui de la figure 5 et diffère uniquement par la présence de résistances commutables connectées en parallèle des résistances 456 et 457.

Le circuit 45 comporte ainsi une résistance 461 et un interrupteur 463 connectés en parallèle de la résistance 456, une résistance 465 et un interrupteur 467 connectés en parallèle de la résistance 456, une résistance 462 et un interrupteur 464 connectés en parallèle de la résistance 457, une résistance 466 et un interrupteur 468 connectés en parallèle de la résistance 457.

L'amplitude de la résistance 461 est inférieure à l'amplitude de la résistance 456. De même, l'amplitude de la résistance 465 est inférieure à l'amplitude de la résistance 461. L'amplitude de la résistance 462 est inférieure à l'amplitude de la résistance 457. De même, l'amplitude de la résistance 466 est inférieure à l'amplitude de la résistance 462.

En l'absence de courant de défaut d'isolement détecté par le microcontrôleur 453, le circuit de commande 8 maintient les interrupteurs 463, 464, 467 et 468 ouverts. Le microcontrôleur 453 ou le circuit de commande 8 détermine la présence d'un défaut d'isolement lorsque la tension mesurée sur l'entrée 491 se décale au-delà d'un premier seuil prédéterminé. Lorsque ce premier seuil de décalage est franchi, le circuit de commande 8 procède à la fermeture des interrupteurs 463 et 464 pour accroître la sensibilité de mesure du microcontrôleur 453. La fermeture des interrupteurs 463 et 464 est à la fois transitoire pour limiter la consommation électrique, et simultanée. Lorsque la tension mesurée sur l'entrée 491 se décale au-delà d'un deuxième seuil prédéterminé, le circuit de commande 8 procède à la fermeture des interrupteurs 467 et 468 pour accroître encore la sensibilité de mesure du microcontrôleur 453. La fermeture des interrupteurs 467 et 468 est à la fois transitoire pour limiter la consommation électrique, et simultanée.

Pour que la tension sur l'entrée 491 reste comprise entre la tension de masse et Vcc en cas de court-circuit entre la masse 93 et l'une des bornes de la batterie 2, les impédances 456 et 457 présentent chacune une impédance au plus de Ztmax, avec Ztmax = Z * Vcc/2Vm. Pour que la tension sur l'entrée 491 reste suffisante pour garantir une précision optimale de la quantification du défaut d'isolement, les impédances 456 et 457 présentent chacune une impédance au mons de Ztmin, avec Ztmin = Z * Vcc/4Vm.

Dans les installations électriques en alternatif, les régimes de neutre les plus courants sont :
- le régime TT : le neutre de l'installation est relié à la terre coté générateur et les masses métalliques sont reliées à la terre;
- le régime TN : le neutre de l'installation est relié à la terre coté générateur et les masses métalliques sont reliées au neutre ;
- le régime IT : le neutre de l'installation est isolé de la terre ou relié par une impédance élevée coté générateur et les masses métalliques sont reliées à une prise de terre.

Le régime de neutre définit ainsi la façon dont le neutre est raccordé d'une part, et la façon dont les masses sont raccordées côté utilisateur d'autre part. Les schémas de liaison à la terre ont pour but de protéger les personnes et le matériel en maîtrisant les défauts d'isolement.

Le schéma de liaison à la terre de la batterie 2 est assimilable à un régime de neutre IT d'un réseau électrique, c'est-à-dire un neutre isolé par rapport à la terre et une masse mécanique raccordée à la terre (sauf en roulage où la masse mécanique est isolée de la terre par l'intermédiaire des pneumatiques). Un tel schéma de liaison à la terre permet d'assurer la continuité de service du véhicule lors de l'apparition d'un premier défaut d'isolement. L'utilisateur peut ainsi continuer à contrôler le véhicule pour l'arrêter dans de bonnes conditions de sécurité.

Pour assurer la recharge de la batterie 2 par un réseau électrique, on raccorde généralement un chargeur isolé à courant alternatif connecté sur le réseau. Dans ce cas le régime IT est conservé. Par contre, un chargeur isolé galvaniquement est plus cher qu'un chargeur non isolé. Avec un chargeur non isolé, on se retrouve en régime TT durant la charge, ce qui revient à connecter la terre au potentiel -Vbat de la batterie 2 lors des alternances positives du réseau électrique. Un courant transite alors par la terre durant ces alternances.

## Revendications

1. Dispositif d'alimentation électrique, comprenant :
- une source de tension continue susceptible d'induire une électrocution (2), appliquant une tension nominale Vm entre ses bornes ;
- un dispositif de détection (4) d'un défaut d'isolement de la source de tension continue (2), comprenant :
- des première et deuxième bornes d'entrée (47, 48) connectées aux bornes de la source de tension;
- des première et deuxième résistances (41, 42) connectées en série entre les première et deuxième bornes d'entrée (47, 48), et configurées pour que le courant de défaut d'isolement entre une desdites bornes de la source de tension et une masse électrique (93) traverse la première résistance ou la deuxième résistance, les première et deuxième résistances présentant chacune une valeur d'impédance Z comprise entre Zmin et Zmax, avec Zmin= Vm/Imax et Zmax=1,5*Vm/Imax, Imax étant un courant de défaut d'isolement de 3,5 mA;
- un circuit de détection de courant (45) connecté entre une masse électrique et un point intermédiaire (49) entre les première et deuxième résistances, le circuit de détection de courant (45) comprenant un microcontrôleur (453) comportant une borne d'entrée connectée audit point intermédiaire, ladite borne d'entrée étant connectée par l'intermédiaire d'une troisième résistance (456) à une alimentation à un niveau de tension Vcc au moins dix fois inférieur au niveau de tension de la source de tension continue;
**caractérisé en ce que** ladite borne d'entrée est par ailleurs connectée à la masse électrique (93) par l'intermédiaire d'une quatrième résistance (457), et reçoit une tension proportionnelle au courant de défaut d'isolement provenant du point intermédiaire (49), ledit microcontrôleur (453) étant configuré pour déterminer l'amplitude d'un défaut d'isolement en fonction de la tension appliquée sur sa borne d'entrée, les troisième et quatrième résistances présentant chacune une valeur d'impédance Zt comprise entre Ztmin et Ztmax, avec Ztmin = Z*Vcc/(4*Vm) et Ztmax = Z * Vcc/2Vm.

2. Dispositif d'alimentation électrique selon l'une quelconque des revendications précédentes, comprenant :
- un premier interrupteur (43) connecté en série avec la première résistance entre la première borne d'entrée et le point intermédiaire ;
- un deuxième interrupteur (44) connecté en série avec la deuxième résistance entre la deuxième borne d'entrée et le point intermédiaire ;
- un circuit de commande (8) configuré pour simultanément maintenir un desdits premier et deuxième interrupteurs ouvert et l'autre desdits premier et deuxième interrupteurs fermé.

3. Dispositif d'alimentation électrique selon l'une quelconque des revendications précédentes, comportant une première diode (454) connectée en parallèle de la troisième résistance et une deuxième diode (455) connectée en parallèle de la quatrième résistance.

4. Dispositif d'alimentation électrique selon l'une quelconque des revendications précédentes, dans lequel les troisième et quatrième résistances (456,457) sont des résistances sensiblement identiques.

5. Dispositif d'alimentation électrique selon l'une quelconque des revendications précédentes, comprenant :
- une cinquième résistance (461) connectée en parallèle de la troisième résistance et présentant une valeur d'impédance inférieure à la troisième résistance ;
- une sixième résistance (462) connectée en parallèle de la quatrième résistance et présentant une valeur d'impédance inférieure à la quatrième résistance ;
- un troisième interrupteur (463) connecté en série avec la cinquième résistance ;
- un quatrième interrupteur (464) connecté en série avec la sixième résistance.

6. Dispositif d'alimentation électrique selon la revendication 5, comprenant un circuit de commande (8) configuré pour fermer transitoirement et simultanément les troisième et quatrième interrupteurs (463,464).

7. Dispositif d'alimentation électrique selon la revendication 6, dans lequel le circuit de commande (8) est configuré pour déterminer que l'amplitude du défaut d'isolement dépasse un seuil et configuré pour fermer transitoirement lesdits troisième et quatrième interrupteurs lorsqu'un franchissement dudit seuil est déterminé.

8. Dispositif d'alimentation électrique selon la revendication 6 ou 7, dans lequel le microcontrôleur (453) génère un signal proportionnel à la tension du point intermédiaire (49) et fournit le signal généré audit circuit de commande.

9. Dispositif d'alimentation électrique selon l'une quelconque des revendications précédentes, dans lequel le niveau de tension de ladite alimentation est inférieur à 25V.

10. Dispositif d'alimentation électrique selon l'une quelconque des revendications précédentes, dans lequel les première et deuxième résistances (454, 455) présentent une valeur d'impédance supérieure ou égale à 100kΩ.

11. Dispositif d'alimentation électrique selon l'une quelconque des revendications précédentes, dans lequel les première et deuxième résistances sont des résistances sensiblement identiques.

12. Système de motorisation (1), comprenant :
- un dispositif d'alimentation électrique selon l'une quelconque des revendications précédentes, dans lequel la source de tension continue est une batterie ;
- un onduleur (6) présentant une interface continu et une interface alternatif, les bornes de la batterie étant connectées à l'interface continu ;
- un moteur électrique (7) connecté à l'interface alternatif de l'onduleur (6).

13. Système de motorisation selon la revendication 12, dans lequel la tension aux bornes de la batterie (2) est supérieure à 100 V.

## Patentansprüche

1. Vorrichtung zur Stromversorgung, welche umfasst:
- eine Gleichspannungsquelle (2), die in der Lage ist, einen elektrischen Schlag zu verursachen, und eine Nennspannung Vm zwischen ihren Anschlussklemmen anlegt;
- eine Vorrichtung zur Erkennung (4) eines Isolationsfehlers der Gleichspannungsquelle (2), welche umfasst:
- eine erste und eine zweite Eingangsklemme (47, 48), die mit den Anschlussklemmen der Spannungsquelle verbunden sind;
- einen ersten und einen zweiten Widerstand (41, 42), die zwischen der ersten und zweiten Eingangsklemme (47, 48) in Reihe geschaltet sind und dafür ausgelegt sind, dass der Isolationsfehlerstrom zwischen einer der Anschlussklemmen der Spannungsquelle und einer elektrischen Masse (93) durch den ersten Widerstand oder den zweiten Widerstand fließt, wobei der erste und der zweite Widerstand jeweils einen Impedanzwert Z zwischen Zmin und Zmax aufweisen, mit Zmin = Vm/Imax und Zmax = 1,5*Vm/Imax, wobei Imax ein Isolationsfehlerstrom von 3,5 mA ist;
- eine Stromdetektionsschaltung (45), die zwischen eine elektrische Masse und einen Zwischenpunkt (49) zwischen dem ersten und dem zweiten Widerstand geschaltet ist, wobei die Stromdetektionsschaltung (45) einen Mikrocontroller (453) umfasst, der eine Eingangsklemme aufweist, die mit dem Zwischenpunkt verbunden ist, wobei diese Eingangsklemme über einen dritten Widerstand (456) mit einer Stromversorgung mit einem Spannungspegel Vcc verbunden ist, der wenigstens zehnmal niedriger als der Spannungspegel der Gleichspannungsquelle ist;
**dadurch gekennzeichnet, dass** die Eingangsklemme außerdem mit der elektrischen Masse (93) über einen vierten Widerstand (457) verbunden ist und eine Spannung empfängt, die zu dem von dem Zwischenpunkt (49) kommenden Isolationsfehlerstrom proportional ist, wobei der Mikrocontroller (453) dafür ausgelegt ist, die Amplitude eines Isolationsfehlers in Abhängigkeit von der an seiner Eingangsklemme anliegenden Spannung zu bestimmen, wobei der dritte und vierte Widerstand jeweils einen Impedanzwert Zt zwischen Ztmin und Ztmax aufweisen, mit Ztmin = Z*Vcc/(4*Vm) und Ztmax = Z*Vcc/2Vm.

2. Vorrichtung zur Stromversorgung nach Anspruch 1, welche umfasst:
- einen ersten Schalter (43), der mit dem ersten Widerstand in Reihe geschaltet ist, zwischen der ersten Eingangsklemme und dem Zwischenpunkt;
- einen zweiten Schalter (44), der mit dem zweiten Widerstand in Reihe geschaltet ist, zwischen der zweiten Eingangsklemme und dem Zwischenpunkt;
- eine Steuerschaltung (8), die dafür ausgelegt ist, gleichzeitig einen von dem ersten und dem zweiten Schalter offen und den anderen von dem ersten und dem zweiten Schalter geschlossen zu halten.

3. Vorrichtung zur Stromversorgung nach einem der vorhergehenden Ansprüche, welche eine erste Diode (454), die zu dem dritten Widerstand parallelgeschaltet ist, und eine zweite Diode (455), die zu dem vierten Widerstand parallelgeschaltet ist, aufweist.

4. Vorrichtung zur Stromversorgung nach einem der vorhergehenden Ansprüche, wobei der dritte und der vierte Widerstand (456, 457) im Wesentlichen identische Widerstände sind.

5. Vorrichtung zur Stromversorgung nach einem der vorhergehenden Ansprüche, welche umfasst:
- einen fünften Widerstand (461), der zu dem dritten Widerstand parallelgeschaltet ist und einen kleineren Impedanzwert als der dritte Widerstand aufweist;
- einen sechsten Widerstand (462), der zu dem vierten Widerstand parallelgeschaltet ist und einen kleineren Impedanzwert als der vierte Widerstand aufweist;
- einen dritten Schalter (463), der mit dem fünften Widerstand in Reihe geschaltet ist;
- einen vierten Schalter (464), der mit dem sechsten Widerstand in Reihe geschaltet ist.

6. Vorrichtung zur Stromversorgung nach Anspruch 5, welche eine Steuerschaltung (8) umfasst, die dafür ausgelegt ist, den dritten und den vierten Schalter (463, 464) vorübergehend und gleichzeitig zu schließen.

7. Vorrichtung zur Stromversorgung nach Anspruch 6, wobei die Steuerschaltung (8) dafür ausgelegt ist zu bestimmen, ob die Amplitude des Isolationsfehlers einen Schwellenwert überschreitet, und dafür ausgelegt ist, den dritten und den vierten Schalter vorübergehend zu schließen, wenn eine Überschreitung des Schwellenwertes bestimmt wird.

8. Vorrichtung zur Stromversorgung nach Anspruch 6 oder 7, wobei der Mikrocontroller (453) ein Signal erzeugt, das zu der Spannung des Zwischenpunktes (49) proportional ist, und das erzeugte Signal der Steuerschaltung zuführt.

9. Vorrichtung zur Stromversorgung nach einem der vorhergehenden Ansprüche, wobei der Spannungspegel der Stromversorgung niedriger als 25 V ist.

10. Vorrichtung zur Stromversorgung nach einem der vorhergehenden Ansprüche, wobei der erste und der zweite Widerstand (454, 455) einen Impedanzwert aufweisen, der größer oder gleich 100 kΩ ist.

11. Vorrichtung zur Stromversorgung nach einem der vorhergehenden Ansprüche, wobei der erste und der zweite Widerstand im Wesentlichen identische Widerstände sind.

12. Motorisierungssystem (1), welches umfasst:
- eine Vorrichtung zur Stromversorgung nach einem der vorhergehenden Ansprüche, wobei die Gleichspannungsquelle eine Batterie ist;
- einen Wechselrichter (6), der eine Gleichstrom-Schnittstelle und eine Wechselstrom-Schnittstelle aufweist, wobei die Anschlussklemmen der Batterie mit der Gleichstrom-Schnittstelle verbunden sind;
- einen Elektromotor (7), der mit der Wechselstrom-Schnittstelle des Wechselrichters (6) verbunden ist.

13. Motorisierungssystem nach Anspruch 12, wobei die Spannung an den Anschlussklemmen der Batterie (2) höher als 100 V ist.

## Claims

1. Electrical power supply device, comprising:
- a DC voltage source liable to induce electrocution (2), applying a nominal voltage Vm between its terminals;
- a device (4) for detecting an insulation defect of the DC voltage source (2), comprising:
- first and second input terminals (47, 48) connected to the terminals of the voltage source;
- first and second resistors (41, 42) connected in series between the first and second input terminals (47, 48), and configured so that the insulation defect current between one of said terminals of the voltage source and an electrical ground (93) passes through the first resistor or the second resistor, the first and second resistors each exhibiting an impedance value Z of between Zmin and Zmax, with Zmin= Vm/lmax and Zmax=1.5*Vm/Imax, Imax being a maximum insulation defect current of 3.5 mA;
- a current-detection circuit (45) connected between an electrical ground and an intermediate point (49) between the first and second resistors, the current-detection circuit (45) comprising a microcontroller (453) comprising an input terminal connected to said intermediate point, said input terminal being connected by way of a third resistor (456) to a power supply with a voltage level Vcc at least ten times lower than the voltage level of the DC voltage source;
**characterized in that** said input terminal is moreover connected to the electrical ground (93) by way of a fourth resistor (457), and receives a voltage proportional to the insulation defect current originating from the intermediate point (49), said microcontroller (453) being configured to determine the amplitude of an insulation defect as a function of the voltage applied to its input terminal, the third and fourth resistors each exhibiting an impedance value Zt of between Ztmin and Ztmax, with Ztmin = Z*Vcc/(4*Vm) and Ztmax = Z * Vcc/2Vm.

2. Electrical power supply device according to claim 1, comprising:
- a first breaker (43) connected in series with the first resistor between the first input terminal and the intermediate point;
- a second breaker (44) connected in series with the second resistor between the second input terminal and the intermediate point;
- a control circuit (8) configured to simultaneously keep one of said first and second breakers open and the other of said first and second breakers closed.

3. Electrical power supply device according to either one of the preceding claims, comprising a first diode (454) connected in parallel with the third resistor and a second diode (455) connected in parallel with the fourth resistor.

4. Electrical power supply device according to any one of the preceding claims, in which the third and fourth resistors (456,457) are substantially identical resistors.

5. Electrical power supply device according to any one of the preceding claims, comprising:
- a fifth resistor (461) connected in parallel with the third resistor and exhibiting a lower impedance value than the third resistor;
- a sixth resistor (462) connected in parallel with the fourth resistor and exhibiting a lower impedance value than the fourth resistor;
- a third breaker (463) connected in series with the fifth resistor;
- a fourth breaker (464) connected in series with the sixth resistor.

6. Electrical power supply device according to Claim 5, comprising a control circuit (8) configured to transiently and simultaneously close the third and fourth breakers (463,464).

7. Electrical power supply device according to Claim 6, in which the control circuit (8) is configured to determine that the amplitude of the insulation defect exceeds a threshold and configured to transiently close said third and fourth breakers when a crossing of said threshold is determined.

8. Electrical power supply device according to Claim 6 or 7, in which the microcontroller (453) generates a signal proportional to the voltage of the intermediate point (49) and provides said control circuit with the signal generated.

9. Electrical power supply device according to any one of the preceding claims, in which the voltage level of said power supply is less than 25 V.

10. Electrical power supply device according to any one of the preceding claims, in which the first and second resistors (454, 455) exhibit an impedance value of greater than or equal to 100 kΩ.

11. Electrical power supply device according to any one of the preceding claims, in which the first and second resistors are substantially identical resistors.

12. Motorization system (1), comprising:
- an electrical power supply device according to any one of the preceding claims, in which the DC voltage source is a battery;
- an inverter (6) exhibiting a DC interface and an AC interface, the terminals of the battery being connected to the DC interface;
- an electric motor (7) connected to the AC interface of the inverter (6).

13. Motorization system according to Claim 12, in which the voltage across the terminals of the battery (2) is greater than 100 V.
